(19) Europäisches Patentamt
European Patent Office
Office européen des brevets

(11) Veröffentlichungsnummer : **0 074 580**
**B1**

(12) **EUROPÄISCHE PATENTSCHRIFT**

(45) Veröffentlichungstag der Patentschrift : **03.12.86**

(51) Int. Cl.⁴ : **G 03 F 7/08**

(21) Anmeldenummer : **82108129.6**

(22) Anmeldetag : **03.09.82**

(54) **Lichtempfindliches, Diazoniumgruppen enthaltendes Polykondensationsprodukt und damit hergestelltes lichtempfindliches Aufzeichnungsmaterial.**

(30) Priorität : **10.09.81 DE 3135804**

(43) Veröffentlichungstag der Anmeldung : **23.03.83 Patentblatt 83/12**

(45) Bekanntmachung des Hinweises auf die Patenterteilung : **03.12.86 Patentblatt 86/49**

(84) Benannte Vertragsstaaten : **DE FR GB**

(56) Entgegenhaltungen :
**FR-A- 2 175 102**
**FR-A- 2 175 955**
**US-A- 3 679 419**
**Die Akte enthält technische Angaben, die nach dem Eingang der Anmeldung eingereicht wurden und die nicht in dieser Patentschrift enthalten sind.**

(73) Patentinhaber : **HOECHST AKTIENGESELLSCHAFT**
**Postfach 80 03 20**
**D-6230 Frankfurt am Main 80 (DE)**

(72) Erfinder : **Lutz, Walter, Dr.**
**Eleonorenstrasse 130**
**D-6503 Mainz-Kastel (DE)**
Erfinder : **Steppan, Hartmut, Dr.**
**Panoramastrasse 17**
**D-6200 Wiesbaden-Dotzheim (DE)**
Erfinder : **Erdmann, Fritz, Dr.**
**Hermann-Hesse-Strasse 39**
**D-6500 Mainz-Lerchenberg (DE)**

**EP 0 074 580 B1**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

**Beschreibung**

Die Erfindung betrifft ein lichtempfindliches Polykondensationsprodukt aus einem aromatischen Diazoniumsalz und einem Dialdehyd sowie ein lichtempfindliches Aufzeichnungsmaterial, dessen lichtempfindliche Schicht das genannte Polykondensationsprodukt enthält.

Es ist bekannt, Polykondensationsprodukte durch Umsetzen von aromatischen Diazoniumsalzen, insbesondere Diphenylamin-4-diazoniumsalzen, mit aktiven Carbonylverbindungen, vorzugsweise Formaldehyd, herzustellen. Derartige Kondensationsprodukte sind in der US-PS 2 063 631 beschrieben. Ihre Verwendung in lichtempfindlichen Aufzeichnungsmaterialien ist z. B. in der US-PS 3 235 383 beschrieben. Solche Aufzeichnungsmaterialien werden in großem Umfang in der Technik genutzt. Dabei haben sich praktisch ausschließlich Produkte durchgesetzt, zu deren Kondensation als Carbonylverbindung Formaldehyd verwendet wird. In den genannten Druckschriften werden als weitere Carbonylverbindungen höhere aliphatische und aromatische Aldehyde, Ketone und Chinone genannt. Auch eine Verbindung mit unterschiedlichen Carbonylgruppen, der Anthrachinon-β-aldehyd, wird erwähnt. Alle diese höheren Carbonylverbindungen zeichnen sich durch eine geringere Reaktionsfähigkeit als Formaldehyd aus. So sind bei ihrer Verwendung in der Regel energischere Reaktionsbedingungen, z. B. konzentriertere Säure oder höhere Temperatur, erforderlich, die wiederum die Bildung von Nebenprodukten begünstigen. Insbesondere führen energische Reaktionsbedingungen auch leicht zu stark vernetzten, unlöslichen Kondensationsprodukten.

In der FR-A-2 175 102 sind ähnliche Kondensationsprodukte mit aliphatischen Aldehyden beschrieben. Als Beispiele werden auch Glyoxal und Glutaraldehyd genannt, jedoch werden nur Ausführungsbeispiele mit Formaldehyd beschrieben.

Obwohl die Formaldehydkondensationsprodukte noch immer in großem Umfang hergestellt und verwendet werden, leiden sie unter dem Nachteil, daß sich ihre Zusammensetzung und Eigenschaften nur in geringem Maße variieren lassen.

Das Problem der Variierbarkeit hat man in jüngerer Zeit dadurch gelöst, daß man gemischte Kondensationsprodukte hergestellt hat, bei deren Herstellung außer Carbonylverbindung und Diazoniumsalz eine weitere, mit Formaldehyd kondensationsfähige Zweitkomponente eingesetzt wird. Diese Produkte und ihre Anwendung sind in der US-A-3 867 147 beschrieben. Sie lassen sich auch durch Kondensation des Diazoniumsalzes mit einer durch Einführung reaktiver Gruppen modifizierten Zweitkomponente herstellen, wobei die reaktiven Gruppen im einfachsten Fall durch Umsetzen von Formaldehyd mit der Zweitkomponente erhalten werden. Diese Kondensationsprodukte liefern sehr hochwertige lichtempfindliche Materialien, insbesondere Druckplatten. Ihre Herstellung ist jedoch komplizierter als die der einfachen Formaldehydkondensationsprodukte, da sie entweder eine schwieriger zu steuernde Kondensationsreaktion von drei Komponenten oder eine Umsetzung in zwei Stufen erfordert.

Aufgabe der Erfindung war es, neue Kondensationsprodukte aromatischer Diazoniumsalze vorzuschlagen, die ähnliche Vorteile wie die bekannten gemischten Kondensationsprodukte aufweisen und die sich einfacher als diese bekannten Produkte herstellen lassen.

Gegenstand der Erfindung ist ein lichtempfindliches, Diazoniumgruppen enthaltendes Polykondensationsprodukt aus einem Dialdehyd und einem Diazoniumsalz der allgemeinen Formel

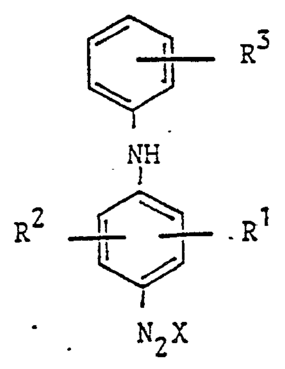

worin

$R^1$, $R^2$ und $R^3$ Wasserstoffatome, Halogenatome, Alkylgruppen mit 1 bis 3 Kohlenstoffatomen oder Alkoxygruppen mit 1 bis 6 Kohlenstoffatomen bedeuten und

X das Anion des Diazoniumsalzes ist.

Das erfindungsgemäße Polykondensationsprodukt ist dadurch gekennzeichnet, daß der Dialdehyd ein aromatischer Dialdehyd oder ein Acetal oder Ester eines aromatischen Dialdehydhydrats ist.

Erfindungsgemäß wird weiterhin ein Verfahren zur Herstellung des Polykondensationsprodukts vorgeschlagen, das darin besteht, daß man ein Diazoniumsalz der oben angegebenen allgemeinen

Formel mit einem aromatischen Dialdehyd oder einem Acetal oder einem Ester eines aromatischen Dialdehydhydrats in einem stark sauren Reaktionsmedium umsetzt.

Erfindungsgemäß wird schließlich noch ein lichtempfindliches Aufzeichnungsmaterial mit einem Schichtträger und einer lichtempfindlichen Schicht vorgeschlagen, die als lichtempfindliche Verbindung das oben definierte Diazoniumgruppen enthaltende Polykondensationsprodukt enthält.

Es wurde gefunden, daß man die Kondensationsreaktion bei Verwendung von aromatischen Dialdehyden bzw. ihren Derivaten als Carbonylverbindungen überraschenderweise unter relativ milden Bedingungen, wie sie auch für die Formaldehydkondensation möglich und bevorzugt sind, durchführen kann, so daß trotz der vielfältigen Reaktionsmöglichkeit dieser Carbonylverbindungen keine hochvernetzten oder unlöslichen Produkte gebildet werden. Im Vergleich zu den Kondensationsprodukten mit aliphatischen Dialdehyden sind die erfindungsgemäßen Kondensationsprodukte besser isolierbar und ergeben Aufzeichnungsmaterialien mit höherer Lichtempfindlichkeit.

Als Derivate von aromatischen Dialdehyden werden die Acetale und die Ester, d. h. die Tetraacylderivate der Dialdehydhydrate, verwendet. Wegen ihrer besseren Reaktionsfähigkeit werden allgemein die Dialdehyde und ihre Acetale, besonders mit niederen Alkoholen mit 1 bis 4, vor allem 1 oder 2 Kohlenstoffatomen, bevorzugt. Von den Estern werden ebenso die niederen Vertreter mit 1 bis 5, vorzugsweise 1 bis 2 Kohlenstoffatomen in der Acylgruppe bevorzugt. Die aromatischen Dialdehyde können einen oder mehrere gegebenenfalls substituierte aromatische Kerne enthalten. Dabei werden die einkernigen oder nicht anellierten zweikernigen Vertreter bevorzugt. Bei den zweikernigen Verbindungen können die Benzolkerne durch eine Einfachbindung oder durch ein Zwischenglied, z. B. ein Ethersauerstoffatom, ein Schwefelatom oder eine kurze Alkylengruppe verbunden sein.

Beispiele für geeignete aromatische Dialdehyde bzw. deren Derivate sind :

Phthaldialdehyd
Terephthaldialdehyd
Diphenyl-4,4'-dialdehyd
Diphenylether-4,4'-dialdehyd-tetramethylacetal

Als Diphenylamin-4-diazoniumsalze werden in an sich bekannter Weise substituierte oder nicht substituierte Verbindungen verwendet. Bevorzugt werden die unsubstituierten oder die durch eine Alkyl- oder besonders eine Alkoxygruppe mit 1 bis 3 Kohlenstoffatomen substituierten Diphenylamin-4-diazoniumsalze bevorzugt. Besonders vorteilhaft sind die Verbindungen, in denen die Alkyl- bzw. Alkoxygruppe in der 3-Stellung steht. Beispiele für geeignete Diazoniumverbindungen sind diejenigen, die sich von den folgenden Aminen ableiten :

4-Amino-3-methoxy-diphenylamin, 4-Amino-diphenylamin, 4-Amino-2-methoxy-diphenylamin, 4'-Amino-2-methoxy-diphenylamin, 4'-Amino-4-methoxy-diphenylamin, 4-Amino-3-methyl-diphenylamin, 4-Amino-3-ethyl-diphenylamin, 4'-Amino-3-methyl-diphenylamin, 4'-Amino-4-methyl-diphenylamin, 4-Amino-3-ethoxy-diphenylamin, 4-Amino-3-hexyloxy-diphenylamin, 4-Amino-3-β-hydroxy-ethoxy-diphenylamin, 4'-Amino-2-methoxy-5-methyl-diphenylamin, 4-Amino-3-methoxy-6-methyl-diphenylamin, 4'-Amino-3,3'-dimethyl-diphenylamin, 3'-Chlor-4-amino-diphenylamin, 4'-Amino-4-n-butoxy-diphenylamin, 4'-Amino-3',4-dimethoxy-diphenylamin, 4-Amino-diphenylamin-2-sulfonsäure, 4-Amino-diphenylamin-2-carbonsäure, 4-Amino-diphenylamin-2'-carbonsäure und 4'-Brom-4-amino-diphenylamin.

Bevorzugt werden 4-Amino-diphenylamin und 3-Methyl-4-amino-diphenylamin. Besonders bevorzugt wird das 3-Methoxy-4-amino-diphenylamin. Als Anion des Diazoniumsalzes wird bevorzugt das Hydrogensulfat verwendet. Die Reaktion findet in stark saurem Medium statt.

Geeignete Kondensationsmittel sind Phosphorsäure, Methansulfonsäure und Schwefelsäure, die in Konzentrationen von mindestens 40, vorzugsweise 70 bis 100, Gewichtsprozent verwendet werden. Der Rest ist im allgemeinen Wasser, kann aber auch ganz oder teilweise aus Lösungsmitteln, z. B. Methanol, Essigsäure, N-Methyl-pyrrolidon und dergleichen, bestehen. Gute Ergebnisse erhält man beispielsweise, wenn man 85 bis 93 %ige Phosphorsäure, 80 %ige Schwefelsäure und 90 %ige Methansulfonsäure oder Mischungen dieser Säuren, verwendet.

80 bis 100 %ige, insbesondere 85 bis 93 %ige Phosphorsäure, ist ein ziemlich mildes Kondensationsmittel, in dem die Kondensation auf sehr schonende Weise durchgeführt werden kann. Es ist deshalb das bevorzugte Kondensationsmittel für alle Kombinationen von Verbindungen, die unter diesen ziemlich schonenden Bedingungen schnell genug reagieren.

80 bis 100 %ige, insbesondere aber 90 %ige Methansulfonsäure, ist ein stärkeres Mittel.

Vorzugsweise verfährt man so, daß man einerseits so wenig Säure, wie möglich verwendet und andererseits ein leicht rührbares und leicht mischbares Kondensationsgemisch erhält. Bei der Auswahl des Typs und der Menge der zu verwendenden Säure sollte man auf die Kondensationsfähigkeit und Löslichkeit der Komponenten in der Säure achten.

Die Kondensation wird im allgemeinen bei Temperaturen von etwa 0 bis 70 °C, vorzugsweise von 10 bis 50 °C, durchgeführt.

Im allgemeinen werden die neuen Polykondensationsprodukte in Form eines Salzes abgeschieden

und in dieser Form nach Zusatz der gewünschten weiteren Schichtbestandteile zur Herstellung des Aufzeichnungsmaterials verwendet.

Die Polykondensationsprodukte können beispielsweise als Salze folgender Säuren abgeschieden und verwendet werden :

Halogenwasserstoffsäuren, wie Fluorwasserstoffsäure, Chlorwasserstoffsäure, Bromwasserstoffsäure, Schwefelsäure, Salpetersäure, Phosphorsäuren (5-wertiger Phosphor), besonders Orthophosphorsäure, anorganische Iso- und Heteropolysäuren, z. B. Phosphorwolframsäure, Phosphormolybdänsäure, aliphatische oder aromatische Phosphonsäuren bzw. deren Halbester, Arsonsäuren, Phosphinsäuren, Trifluoressigsäure, Amidosulfonsäure, Selensäure, Borfluorwasserstoffsäure, Hexafluorphosphorsäure, Perchlorsäure, ferner aliphatische und aromatische Sulfonsäuren, z. B. Methansulfonsäure, Benzolsulfonsäure, Toluolsulfonsäure, Mesitylensulfonsäure, p-Chlorbenzolsulfonsäure, 2,5-Dichlorbenzolsulfonsäure, Sulfosalicylsäure, Naphthalin-1-sulfonsäure, Naphthalin-2-sulfonsäure, 2,6-Di-tert.-butyl-naphthalindisulfonsäure, 1,8-Dinitro-naphthalin-3,6-disulfonsäure, 4,4'-Diazidostilben-3,3'-disulfonsäure, 1,2-Naphthochinon-2-diazid-4-sulfonsäure, 1,2-Naphthochinon-2-diazid-5-sulfonsäure und 1,2-Naphthochinon-1-diazid-4-sulfonsäure.

Weitere organische Sulfonsäuren, die zur Abscheidung der Kondensate in Betracht kommen, sind in den Spalten 2 bis 5 der US-PS 3 219 447 angegeben.

Besonders bevorzugt werden Mesitylensulfonsäure oder Methansulfonsäure.

Für die Herstellung der Polykondensationsprodukte werden gewöhnlich 0,15 bis 2 Mol Dialdehyd je Mol Diazoniumsalz verwendet. Besonders vorteilhaft sind Produkte, die aus 0,35 bis 1,2 Mol Dialdehyd je Mol Diazoniumsalz erhalten werden.

Die Polykondensate mit relativ geringer Menge an Diazoniumsalzen erweisen sich im allgemeinen als weniger gut löslich. Sie zeigen nach ihrer Abscheidung als Mesitylensulfonate bei ihrer kopiertechnischen Austestung auf dem Aluminiumträger erschwerte Entwickelbarkeit.

Ein Vorteil vieler nach dem erfindungsgemäßen Verfahren hergestellten Kondensate besteht darin, daß sie auch in Form von Salzen, die von komplexbildenden Metallsalzen frei sind, leicht abgetrennt werden können. Zum Beispiel geben viele Kondensate Sulfate, Chloride und Bromide, die im Wasser schwerlöslich sind und aus wäßrigen Lösungen der Kondensationsgemische durch Zugabe der entsprechenden Säuren oder ihrer in Wasser löslichen Salze leicht ausgefällt werden können. Das Abtrennungsverfahren wird in den später folgenden Beispielen im einzelnen beschrieben.

Die erfindungsgemäßen Polykondensationsprodukte zeichnen sich durch eine Reihe von Vorteilen gegenüber den bekannten Diazoniumsalz-Polykondensationsprodukten aus. So lassen sie sich im Vergleich zu den älteren Kondensationsprodukten aus Formaldehyd und Diazoniumsalz leichter aus dem Kondensationsmedium abscheiden und damit besser in reiner Form isolieren. Die damit hergestellten lichtempfindlichen Aufzeichnungsmaterialien, insbesondere Druckplatten, weisen eine geringere Empfindlichkeit gegen Eingerabdrücke auf und haben allgemein eine höhere Lichtempfindlichkeit.

In diesen Eigenschaften entsprechen sie im wesentlichen den Mischkondensationsprodukten, die in der US-PS 3 867 147 beschrieben sind. Gegenüber diesen qualitativ hochwertigen Produkten haben die erfindungsgemäßen Produkte den Vorteil, daß sie sich leichter bzw. aus leichter zugänglichen Ausgangsstoffen herstellen lassen.

Zur Herstellung von Kopiermaterialien löst man die Diazoniumsalz-Polykondensate für sich allein oder gegebenenfalls zusammen mit weiteren Schichtbestandteilen in einem geeigneten Lösungsmittel und beschichtet mit der so erhaltenen Lösung den vorgesehenen Träger. Zur Herstellung von Offsetdruckplatten handelt es sich hierbei bevorzugt um metallische Trägermaterialien, insbesondere Aluminium. Dieses wird zuvor im allgemeinen mechanisch oder elektrochemisch aufgerauht, ggf. anodisch oxydiert und vorzugsweise mit einer Lösung von Silikaten, bestimmten Komplexslazen, Phosphonsäuren oder anderen bekannten Mitteln behandelt. Die lichtempfindliche Schicht wird bei Raumtemperatur oder bei erhöhter Temperatur angetrocknet.

Den Kopierschichten können als weitere Bestandteile noch eine Vielzahl von Stoffen zugesetzt werden. Als Beispiele seien genannt :

Säuren

z. B. Phosphorsäure (besonders Orthophosphorsäure), Phosphonsäuren, Phosphinsäuren ; die in der US-Patentschrift 3 235 382 genannten starken Säuren, wie Schwefelsäure oder organische Sulfonsäuren, z. B. Toluolsulfonsäure ; organische Polysäuren, z. B. Polyvinylphosphonsäure.

Wasserlösliche Polymerisate

z. B. Polyvinylalkohol, teilweise verseiftes Polyvinylacetat (Acetylgehalt : bis 40 %), Polyacrylamid u. a.

Wasserunlösliche Polymerisate

z. B. Phenolharze, Epoxyharze, Harnstoff- und Melamin-Harze, Polyvinylacetale, Polyurethane und

Polysulfonylurethane. Druckformen mit beträchtlich höheren Druckauflagen erhält man aus Kopierschichten, welche die Polykondensate in Kombination mit Polyvinylformalharzen enthalten.

Gefärbte Pigmente
Farbstoffe
Weichmacher
Netzmittel

Alle Zusätze sollen so ausgewählt werden, daß sie mit den Diazokondensaten verträglich sind und außerdem in dem für die Lichtzersetzung der Diazoverbindungen wichtigen Wellenängenbereich möglichst wenig absorbieren.

Die Zusätze werden im allgemeinen in den folgenden Mengen verwendet :

Säuren des fünfwertigen Phosphors werden im allgemeinen in einer Menge von 0,01 bis 4 Mol pro Mol Diazogruppen angewendet. Die organischen Polysäuren, soweit sie gut wasserlöslich sind, finden dagegen im allgemeinen nur in einer Menge von 0,01 bis 3 Mol pro Mol Diazogruppen Verwendung.

Die wasserlöslichen Polymeren werden im allgemeinen in einer Menge bis zu 100 Gewichtsteilen je Gt. Diazopolykondensat, vorzugsweise bis zu 20 Gt. eingesetzt.

Der Zusatz von in Wasser unlöslichen Polymerisaten wird im allgemeinen 15 Gewichtsteile je Gt. Diazoverbindung nicht übersteigen, der bevorzugte Bereich liegt bei 0,5 bis 10 Gt.

Wenn die Kopierschichten wasserlösliche und bzw. oder in Wasser unlösliche Polymerisate enthalten, werden ihnen gefärbte oder ungefärbte Pigmente im allgemeinen nur in einer Menge bis zu 50 Gew.-%, bezogen auf die Polymerisate, zugesetzt.

Weichmacher, Farbstoffe, Netzmittel, Sensibilisatoren, Indikatoren und Fettsäuren werden im allgemeinen in Mengen nicht über 20 Gew.-%, bevorzugt nicht über 10 %, bezogen auf die sonstigen Schichtbestandteile, den Kopierschichten einverleibt.

Als Lösungsmittel zur Bereitung der Beschichtungslösungen können je nach den Schichtbestandteilen z. B. Wasser, Alkohole, wie Methanol, Ethanol, Glykolether wie Ethylenglykolmonoethylether, Dimethylformamid, Diethylformamid und dgl. verwendet werden.

Reine oder wenig Wasser enthaltende organische Lösungsmittel werden bevorzugt bei Chloriden, Bromiden und Salzen der neuen Diazokondensate verwendet, die in Wasser weitgehend unlöslich sind, z. B. den Salzen aromatischer Sulfonsäuren, den Tetrafluoroboraten oder den Hexafluorophosphaten. In diesen Fällen setzt man den Alkoholen bzw. Amiden, welche in der Regel gute Lösungsmittel für diese Verbindungen sind, meist noch Lösungsmittel zu, die diese nur schlecht lösen, z. B. Ether wie Dioxan, Tetrahydrofuran, Ester wie Essigsäureethylester, Butylacetat, Ethylenglykolmethyletheracetat, Ketone wie Methylethylketon, Cyclohexanon usw., um die Verlaufeigenschaften der Beschichtungen zu verbessern.

Bei der Verarbeitung wird das Kopiermaterial bildmäßig durch eine Vorlage belichtet. Zur Bildelichtung kann jede in der Reproduktionstechnik gebräuchliche Lichtquelle dienen, die im langwelligen UV-Bereich und im kurzwelligen sichtbaren Bereich emittiert, z. B. Kohlenbogenlampen, Quecksilberhochdrucklampen, Xenonimpulslampen und andere. Auch Elektronen- oder Laserstrahlung ist zur Bildaufzeichnung geeignet.

Nach der Belichtung wird mit einem geeigneten Entwickler entwickelt. Als Entwickler können z. B. Wasser, wäßrige Netzmittellösungen, ggf. unter Zusatz von Alkali, deren Gemische mit organischen Lösungsmitteln, wäßrige Salzlösungen, wäßrige Lösungen von Säuren, z. B. von Phosphorsäuren, denen wiederum Salze oder organische Lösungsmittel zugesetzt werden können, oder auch alkalische Entwickler verwendet werden, z. B. wäßrige Lösungen von Natriumsalzen der Phosphorsäure oder der Kieselsäure. Auch diesen Entwicklern können organische Lösungsmittel zugesetzt werden. Es ist in manchen Fällen auch möglich, mit Wasser verdünnte organische Lösungsmittel zu verwenden. Die Entwickler können noch weitere Bestandteile, z. B. Netzmittel und Hydrophilierungsmittel, enthalten.

Die Entwicklung erfolgt in bekannter Weise, z. B. durch Tauchen und/oder Überwischen oder Besprühen mit der Entwicklerflüssigkeit.

Die nachstehenden Beispiele beschreiben die Herstellung der neuen Diazopolykondensate und der mit diesen hergestellten erfindungsgemäßen Aufzeichnungsmaterialien. Zur näheren Kennzeichnung der verwendeten Diazokondensate ist neben dem Ergebnis der Elementaranalyse in vielen Beispielen noch angegeben, in welchem Holverhältnis — das aus diesen Analysenwerten errechnet wurde — Diazoniumsalz und Dialdehyd am Aufbau des Produkts beteiligt sind. Dieses Verhältnis wurde unter etwas vereinfachenden Annahmen errechnet. Diese Angaben können und sollen keine Aussagen über die genaue Struktur der erfindungsgemäßen Kondensate machen.

Sie reichen jedoch aus zur Identifizierung von Kondensationsprodukten, die in ihren Eigenschaften reproduzierbar sind.

Wie bereits oben erwähnt, sind in vielen Fällen zur weiteren Kennzeichnung die Bedingungen der Kondensation, insbesondere auch die eingesetzten Mengenverhältnisse, wichtig. Die Beispiele enthalten alle für die Herstellung der Kondensate erforderlichen Angaben.

In den Beispielen stehen Gewichtsteile (Gt.) und Volumenteile (Vt.) zueinander im Verhältnis von g zu ml. Prozentangaben sind, wenn nichts anderes angegeben ist, Gewichtsprozente, Temperaturen sind in

°C angegeben. Bei den Analysenwerten bedeutet N den Gesamtstickstoffgehalt.

Als « Rohkondensat » wird in den Beispielen im allgemeinen das bei der Kondensation anfallende rohe Kondensationsgemisch bezeichnet, das normalerweise noch das Kondensationsmedium enthält.

Beispiel 1

In 200 Gt. 90 %iger Methansulfonsäure wurden 32,4 Gt. 3-Methoxy-diphenylamin-4-diazoniumsulfat bei Raumtemperatur gelöst. In diese Lösung wurden 31,8 Gt. Diphenylether-4,4'-dialdehyd-tetramethylacetal gegeben und das Gemisch bei 40 °C 22 Stunden kondensiert. Das klare Rohkondensat wurde in 2 000 Vt. Wasser gegossen. Es bildete sich ein Niederschlag. Das Rohkondensat wurde durch 2 400 Vt. gesättigte Kochsalzlösung mittels Umsalzen in das Chlorid übergeführt. Der dabei gebildete Niederschlag wurde in 2 000 Vt. Wasser suspendiert und mit 50 Gt. mesitylensulfonsaurem Natrium in das Mesitylensulfonat übergeführt. Es wurden 35 Gt. eines Kondensats erhalten (C : 67,5 %, H : 5,4 %, N : 6,4 %, S : 4,9 % ; C : H : N : S 37 : 35 : 3 : 1). Dies bedeutet, daß im Kondensat pro Diazogruppe 1,02 Einheiten aus Dialdehyd vorliegen. Das Diazopolykondensat war sehr gut in Ethylenglykolmonomethylether löslich.

Beispiel 2

In 200 Gt. 90 %iger Methansulfonsäure wurden 58,4 Gt. Diphenylamin-4-diazoniumsulfat gelöst. In diese Lösung wurden 31,8 Gt. Diphenylether-4,4'-dialdehyd-tetramethylacetal eingetropft und das Gemisch 22 Stunden bei 40 °C kondensiert. Das Rohkondensat wurde in 2 000 Vt. Wasser gegossen, wobei eine klare Lösung erhalten wurde. Mit Hilfe von 2 400 Vt. gesättigter Kochsalzlösung wurde das Kondensat als Chlorid vom Kondensationsmedium abgetrennt. Es wurde in 5 000 Vt. Wasser gelöst und durch 50 Gt. mesitylensulfonsaures Natrium in das Mesitylensulfonat übergeführt. Es wurden 42 Gt. Kondensat erhalten (C : 66,5 %, H : 5,5 %, N : 7,9 %, S : 6,0 % ; C : H : N : S 29,5 : 2,3 : 3 : 1). Im Kondensat lagen je Diazogruppe 0,6 Einheiten aus Dialdehyd vor.

Beispiel 3

In 200 Gt. 90 %iger Methansulfonsäure wurden 58,6 Gt. Diphenylamin-4-diazoniumsulfat gelöst. In diese Lösung wurden 21 Gt. Diphenyl-4,4'-dialdehyd zugegeben, und danach wurde 20 Stunden bei 40 °C kondensiert. Das Rohkondensat wurde in 4 000 Vt. Wasser gegossen, wobei eine klare Lösung erhalten wurde. Die Abtrennung des Kondensats erfolgte durch Zusatz von 2 400 Vt. gesättigter Kochsalzlösung. Das Chlorid wurde in 4 000 Vt. Wasser gelöst und durch 50 Gt. mesitylensulfonsaures Natrium in das Mesitylensulfonat übergeführt. Es wurden 38 Gt. Kondensat erhalten (C : 70,4 %, H : 5,0 %, N : 8,3 %, S : 6,1 % ; C : H : N : S 29,7 : 25,3 : 3 : 0,97). Im Kondensat sind je Diazogruppe 0,6 Einheiten aus Dialdehyd enthalten.

Beispiel 4

In 200 Gt. 93 %iger Phosphorsäure wurden 64,8 Gt. 3-Methoxydiphenylamin-4-diazoniumsulfat gelöst, und es wurden 26,8 Gt. o-Phthaldialdehyd bei Raumtemperatur zugegeben. Die Reaktionsmischung wurde 20 Std. bei 40 °C kondensieren gelassen. Das Rohkondensat wurde in 4 000 Vt. Wasser gegossen, wobei eine klare Lösung entstand. Mittels 4 800 Vt. gesättigter Kochsalzlösung wurde das Rohkondensat in das entsprechende Chlorid übergeführt. Der Niederschlag wurde in 4 000 Vt. Wasser gelöst und mit 20 Gt. mesitylensulfonsaurem Natrium erneut ausgefällt. Es wurden 80 Gt. eines Kondensates erhalten mit folgender Elementaranalyse : C : 62,4 %, H : 5,3 %, N : 7,1 %, S : 5,1 % ; C : H : N : S 31 : 31 : 3 : 0,95. Dies bedeutet, daß im Kondensat 1,0 Mol o-Phthaldialdehydeinheiten auf 1 Mol Diazoniumgruppen kommt.

Beispiel 5

Diazoverbindung : 3-Methoxy-diphenylamin-4-diazoniumsulfat
Aldehyd : Terephthaldialdehyd

| | A | | B | | C | |
|---|---|---|---|---|---|---|
| | Diazo | Dialdehyd | Diazo | Dialdehyd | Diazo | Dialdehyd |
| Molverhältnis | 1 | 1 | 1,5 | 1 | 2 | 1 |
| Gt. | 64,8 | 26,8 | 97,2 | 26,8 | 129,6 | 26,8 |

In je 200 Gt. 90 %iger Methansulfonsäure wurden bei Raumtemperatur obige Verbindungen gelöst. Danach wurde bei 40 °C 15 Stunden kondensiert. Die Reaktionsmischungen wurden in je 4 000 Vt.

Wasser gegossen. Bei äquimolarer Menge an Diazoverbindung und Dialdehyd wurde ein Niederschlag erhalten, während die Zusammensetzungen B und C nur wenig bzw. überhaupt keinen Niederschlag bildeten. Die Abscheidung der Kondensate erfolgte mit 2 400 Vt. gesättigter Kochsalzlösung. Das als Chlorid abgeschiedene Rohkondensat nimmt in der Reihe A-C in seiner Löslichkeit in 4 000 Vt. Wasser ab. Es wurde mit mesitylensulfonsaurem Natrium in das Mesitylensulfonat übergeführt.

| A | | B | | C | |
|---|---|---|---|---|---|
| 97,6 Gt. Na-Mesitylensulfonat | | 73,2 Gt. Na-Mesitylensulfonat | | 48,8 Gt. Na-Mesitylensulfonat | |
| 14,1 Gt. Ausbeute | | 11,0 Gt. Ausbeute | | 7,5 Gt. Ausbeute | |
| Analyse | Atomverhältn. | Analyse | Atomverhältn. | Analyse | Atomverhältn. |
| % | | % | | % | |
| C 65,7 | 33,3 | C 64,8 | 44,2 | C 65,1 | 62,5 |
| H 5,2 | 31,6 | H 5,4 | 44,2 | H 5,2 | 58,4 |
| N 6,9 | 3 | N 7,7 | 4,5 | N 7,3 | 6 |
| S 5,2 | 0,98 | S 5,8 | 1,5 | S 5,7 | 2 |

Molverhältnis Diazoniumgruppen : Dialdehydeinheit

| A | B | C |
|---|---|---|
| 1 : 1,1 | 1,5 : 1,0 | 2 : 1,03 |

Beispiel 6

Die in den Beispielen 1 bis 5 beschriebenen Kondensate wurden auf einen elektrolytisch aufgerauhten und mit Polyvinylphosphonsäure vorbehandelten Aluminiumträger aufgebracht. Anschließend wurde die Beschichtung mit Warmluft angetrocknet. Hierfür wurde eine Beschichtungslösung folgender Zusammensetzung verwendet :

5 Gt. Diazokondensat
0,5 Gt. 85 %iger Phosphorsäure
0,5 Gt. Viktoriareinblau FGA (C.I. Basic Blue 81)
95 Gt. Ethylenglykolmonomethylether

Die Platten wurden mit einer 5 kW Metallhalogenid-Lampe im Abstand von 100 cm zwischen Lampe und Vakuumkopierrahmen durch eine Negativvorlage 30 Sekunden belichtet. Die Entwicklung des belichteten Materials erfolgte mit einem Entwickler folgender Zusammensetzung :

15 Gt. Pelargonsäure
10 Gt. NaOH
92 Gt. eines Blockcopolymerisats aus 90 % Propylenoxid und 10 % Ethylenoxid
12 Gt. Natriumtetrapolyphosphat
550 Gt. Wasser

Beispiel 7

In 200 Gt. 90 %iger Methansulfonsäure wurden 64,8 Gt. 3-Methoxy-diphenylamin-4-diazoniumsulfat gelöst. In diese Lösung wurden 13,4 Gt. Terephthaldialdehyd eingestreut, und das Gemisch wurde 19 Stunden bei 40 °C kondensiert. Das Rohkondensat wurde in 2 000 Vt. Wasser gegossen. Es wurde eine klare Lösung erhalten. Die Abtrennung des Kondensats erfolgte mit 1 200 Vt. gesättigter Kochsalzlösung. Das Chlorid wurde in 1 000 Vt. Wasser suspendiert und mit 600 Vt. gesättigter wäßriger Lösung von Natriummethansulfonat umgefällt. Der Niederschlag wurde nach dem Absaugen in 800 Vt. Wasser gelöst und mit 1 200 Vt. gesättigter wäßriger Lösung von Natriummethansulfonat erneut ausgefällt. Es wurden 34 Gt. Kondensat erhalten (C : 53.3 %, H : 4,8 %, N : 8,5 %, S : 8,0 % ; C : H : N : S 22 : 23,7 : 3 : 1,2). Im Kondensat liegen äquimolare Mengen an Diazoniumgruppen und Dialdehydeinheiten vor.

Herstellung einer Siebdruckform

Zu 100 Gt. einer Siebdruckemulsion, die aus 3 Gt. einer 53 %igen Dispersion eines Vinylacetat-Maleinsäureester-Mischpolymerisats und 2 Gt. einer 24 %igen Lösung eines Polyvinylalkohols mit dem K-Wert 75 und einem Restacetylgruppengehalt von etwa 12 % bestand, wurde eine Lösung von 0,7 Gt. des oben beschriebenen Kondensats in 12 Vt. Wasser zugegeben. Die Suspension wurde mit 5 Vt. einer 5 %igen Kristallviolett-Lösung angefärbt. Damit wurde ein Polyestersiebdruckgewebe wie üblich beschichtet, dann getrocknet, belichtet und mit Wasser entwickelt und erneut getrocknet. Die Schicht zeigte eine auffallend gute Auflösung und Lichtempfindlichkeit.

Beispiel 8

Die in Beispiel 5 beschriebenen Kondensate ließen sich mit folgenden in Lösungsmitteln löslichen Harzen kombinieren :

Polyvinylbutyral, enthaltend 69-71 % Polyvinylbutyral-, 1 % Polyvinylacetat- und 24 bis 27 % Polyvinylalkoholeinheiten. Die Viskosität einer 6 %igen Lösung bei 20 °C betrug 4 bis 6 mPa · s (DIN 53 015).

Nichtplastifiziertes Harnstoffharz des ungefähren Säurezahl 2

Die Harze wurden mit den Kondensaten nach folgender Rezeptur gemischt :

1 Gt. Kondensat
0,1 Gt. 85 %iger Phosphorsäure
3 Gt. Harz
0,4 Gt. Viktoriareinblau FGA
77 Gt. Ethylenglykolmonomethylether

Die Platten wurden nach dem Trocknen 40 Sekunden unter einem Negativ mittels einer Metallhalogenidlampe von 5 kW im Abstand von 1 m bildmäßig belichtet und anschließend durch Überwischen mit einem Entwickler der folgenden Zusammensetzung in Druckformen umgewandelt, welche besonders im Falle des Polyvinylbutyrals eine sehr gute Auflagenstabilität zeigten :

50 Gt. Wasser
15 Gt. Isopropanol
20 Gt. n-Propanol
12,5 Gt. n-Propylacetat
1,5 Gt. Polyacrylsäure
1,5 Gt. Essigsäure

Beispiel 9

Eine mit dünner Kupferfolie kaschierte Kunststoffplatte wurde nach der Reinigung der Kupferoberfläche mit Scheuermittel und Abspülen mit Aceton mit der nachstehenden Lösung beschichtet :

1,0 Gt. des in Beispiel 7 beschriebenen Kondensats
3,0 Gt. eines Kresol-Formaldehyd-Novolaks mit einem Erweichungsbereich von 105-120 °C nach DIN 53 181
40 Gt. Ethylenglykolmonomethylether
0,05 Gt. Kristallviolett.

Es wurde ein Schichtgewicht von 2 g/m$^2$ eingestellt. Die Platte wurde unter einem Positiv, welches ein Schaltschema darstellt, 2 Minuten mit einer 5 KW-Metallhalogenid-Lampe im Abstand von 100 cm zwischen Lampe und Vakuumkopierrahmen belichtet. Die Entwicklung erfolgte mit einem Entwickler mit folgender Zusammensetzung, wobei die belichteten Schichtbereiche abgelöst wurden :

3 Gt. Natriumhydroxid
3 Gt. Natriummetasilikat × 12 $H_2O$
4 Gt. Ethylenglykolmonobutylether
90 Gt. Wasser

Durch Wegätzen des Kupfers an den freigelegten Stellen mit 40 %iger wäßriger Eisen-(III)-chlorid-Lösung wurde eine kopierte Schaltung erhalten.

**Patentansprüche**

1. Lichtempfindliches, Diazoniumgruppen enthaltendes Polykondensationsprodukt aus einem Dialdehyd und einem Diazoniumsalz der allgemeinen Formel

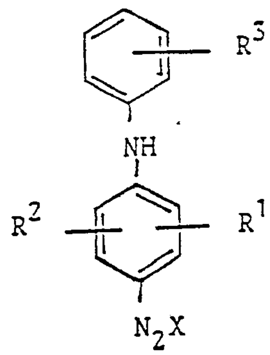

worin

$R^1$, $R^2$ und $R^3$ Wasserstoffatome, Halogenatome, Alkylgruppen mit 1 bis 3 Kohlenstoffatomen oder Alkoxygruppen mit 1 bis 6 Kohlenstoffatomen bedeuten und

X das Anion des Diazoniumsalzes ist,

dadurch gekennzeichnet, daß der Dialdehyd ein aromatischer Dialdehyd oder ein Acetal oder Ester eines aromatischen Dialdehydhydrats ist.

2. Lichtempfindliches Polykondensationsprodukt nach Anspruch 1, dadurch gekennzeichnet, daß der aromatische Dialdehyd einen oder zwei nicht anellierte aromatische Ringe enthält.

3. Lichtempfindliches Polykondensationsprodukt nach Anspruch 1, dadurch gekennzeichnet, daß das Diazoniumsalz ein Diphenylamin-4-diazoniumsalz oder ein 3-Methoxydiphenylamin-4-diazoniumsalz ist.

4. Lichtempfindliches Polykondensationsprodukt nach Anspruch 1, dadurch gekennzeichnet, daß es 0,15 bis 2 aus Dialdehyd entstandene Einheiten je Diazoniumsalzeinheit enthält.

5. Verfharen zur Herstellung eines lichtempfindlichen, Diazoniumgruppen enthaltenden Polykondensationsprodukts gemäß Anspruch 1, dadurch gekennzeichnet, daß man ein Diazoniumsalz der allgemeinen Formel

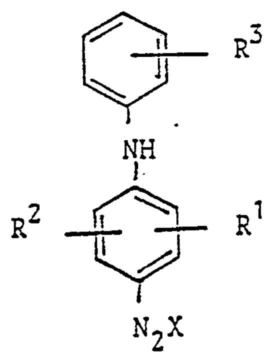

worin

$R^1$, $R^2$ und $R^3$ Wasserstoffatome, Halogenatome, Alkylgruppen mit 1 bis 3 Kohlenstoffatomen oder Alkoxygruppen mit 1 bis 6 Kohlenstoffatomen bedeuten und

X das Anion des Diazoniumsalzes ist,

mit einem aromatischen Dialdehyd, einem Acetal oder einem Ester eines aromatischen Dialdehydhydrats in stark saurem Medium umsetzt.

6. Lichtempfindliches Aufzeichnungsmaterial mit einem Schichtträger und einer lichtempfindlichen Schicht, die als lichtempfindliche Verbindung ein Diazoniumgruppen enthaltendes Polykondensationsprodukt aus einem Dialdehyd und einem Diazoniumsalz der allgemeinen Formel

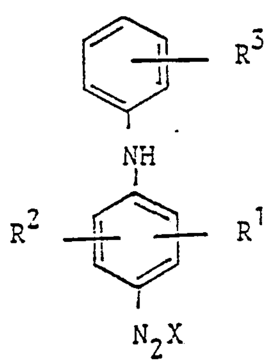

enthält, worin

$R^1$, $R^2$ und $R^3$ Wasserstoffatome, Halogenatome, Alkylgruppen mit 1 bis 3 Kohlenstoffatomen oder Alkoxygruppen mit 1 bis 6 Kohlenstoffatomen bedeuten und

X das Anion des Diazoniumsalzes ist,

dadurch gekennzeichnet, daß der Dialdehyd ein aromatischer Dialdehyd oder ein Acetal oder Ester eines aromatischen Dialdehydhydrats ist.

**Claims**

1. Light-sensitive, diazonium group-containing polycondensation product of an aldehyde and a diazonium salt of the general formula

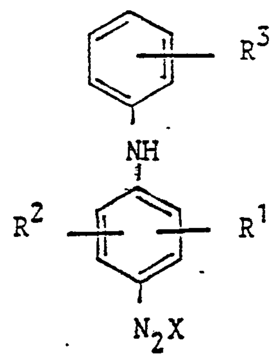

wherein

$R^1$, $R^2$ and $R^3$ denote hydrogen atoms, halogen atoms, alkyl groups having 1 to 3 carbon atoms or alkoxy groups having 1 to 6 carbon atoms, and

X denotes the anion of the diazonium salt,

said polycondensation product being characterized in that the aldehyde is an aromatic dialdehyde or an acetal or ester of an aromatic dialdehyde hydrate.

2. Light-sensitive polycondensation product as claimed in Claim 2, wherein the aromatic dialdehyde contains one or two non-fused aromatic rings.

3. Light-sensitive polycondensation product as claimed in Claim 1, wherein the diazonium salt is a diphenylamine-4-diazonium salt or a 3-methoxydiphenylamine-4-diazonium salt.

4. Light-sensitive polycondensation product as claimed in Claim 1, which contains 0.15 to 2 units formed from dialdehyde per diazonium salt unit.

5. Process for the preparation of a light-sensitive polycondensation product containing diazonium groups, as claimed in Claim 1, wherein a diazonium salt of the general formula

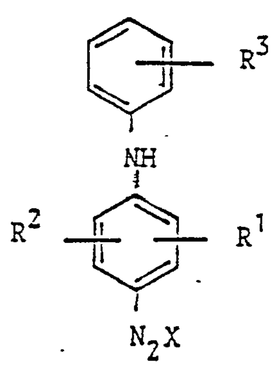

wherein

$R^1$, $R^2$ and $R^3$ denote hydrogen atoms, halogen atoms, alkyl groups having 1 to 3 carbon atoms or alkoxy groups having 1 to 6 carbon atoms, and

X denotes the anion of the diazonium salt,

is reacted with an aromatic dialdehyde, an acetal or an ester of an aromatic dialdehyde hydrate in a strongly acid medium.

6. Light-sensitive recording material comprising a layer support and a light-sensitive layer which contains, as the light-sensitive compound, a diazonium group-containing polycondensation product of an aldehyde and a diazonium salt of the general formula

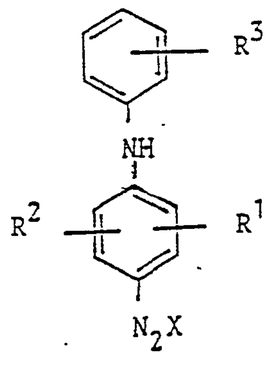

wherein

$R^1$, $R^2$ and $R^3$ denote hydrogen atoms, halogen atoms, alkyl groups having 1 to 3 carbon atoms or alkoxy groups having 1 to 6 carbon atoms, and

X denotes the anion of the diazonium salt,

characterized in that the aldehyde is an aromatic dialdehyde or an acetal or an ester of an aromatic dialdehyde hydrate.

**Revendications**

1. Produit de polycondensation photosensible, contenant des groupes diazonium, obtenu à partir d'un dialdéhyde et d'un sel de diazonium de formule générale

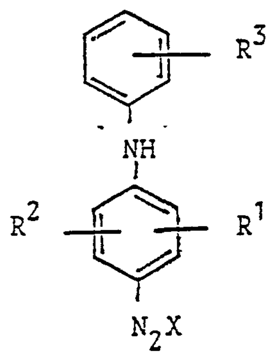

dans laquelle

$R^1$, $R^2$ and $R^3$ représentent des atomes d'hydrogène, des atomes d'halogène, des groupes alkyle ayant de 1 à 3 atomes de carbone ou des groupes alcoxy ayant de 1 à 6 atomes de carbone, et

X est l'anion du sel de diazonium,

caractérisé en ce que le dialdéhyde est un dialdéhyde aromatique ou un acétal ou ester d'un hydrate de dialdéhyde aromatique.

2. Produit de polycondensation photosensible selon la revendication 1, caractérisé en ce que le dialdéhyde aromatique contient un ou deux noyaux aromatiques non condensés.

3. Produit de polycondensation photosensible selon la revendication 1, caractérisé en ce que le sel de diazonium est un sel de diphénylamine-4-diazonium ou un sel de 3-méthoxydiphénylamine-4-diazonium.

4. Produit de polycondensation photosensible selon la revendication 1, caractérisé en ce qu'il contient 0,15 à 2 unités formées à partir de dialdéhyde, par unité de sel de diazonium.

5. Procédé pour la préparation d'un produit de polycondensation photosensible, contenant des groupes diazonium, selon la revendication 1, caractérisé en ce que l'on fait réagir, en milieu fortement acide, un sel de diazonium de formule générale

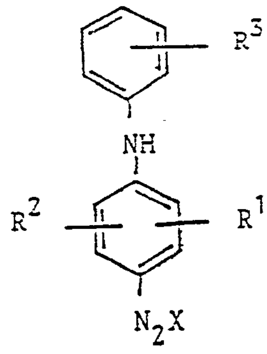

dans laquelle

$R^1$, $R^2$ et $R^3$ représentent des atomes d'hydrogène, des atomes d'halogène, des groupes alkyle ayant de 1 à 3 atomes de carbone ou des groupes alcoxy ayant de 1 à 6 atomes de carbone, et

X est l'anion du sel de diazonium,

avec un dialdéhyde aromatique, un acétal ou un ester d'un hydrate de dialdéhyde aromatique.

6. Matériau d'enregistrement photosensible comportant un support de couche et une couche photosensible, qui contient en tant que composé photosensible un produit de polycondensation, contenant des groupes diazonium, obtenu à partir d'un dialdéhyde et d'un sel de diazonium de formule générale

dans laquelle

$R^1$, $R^2$ et $R^3$ représentent des atomes d'hydrogène, des atomes d'halogène, des groupes alkyle ayant de 1 à 3 atomes de carbone ou des groupes alcoxy ayant de 1 à 6 atomes de carbone, et

X est l'anion du sel de diazonium,

caractérisé en ce que le dialdéhyde est un dialdéhyde aromatique ou un acétal ou ester d'un hydrate de dialdéhyde aromatique.